# EUROPÄISCHE PATENTANMELDUNG

(11) **EP 4 827 257 A1**
(43) Veröffentlichungstag der Anmeldung: **21.10.2026**
(21) Anmeldenummer: 26161795.5
(22) Anmeldetag: 02.03.2026
(51) Int. Cl.: H05K 7/20, H02M 7/00, H05K 5/02, H10W 40/25, H10W 40/47, H10W 76/01

(54) **LEISTUNGSELEKTRONIK MIT KÜHLKÖRPER**

(30) Priorität: 16.04.2025 DE 102025115054
(71) Anmelder: Volkswagen Aktiengesellschaft, 38440 Wolfsburg (DE)
(72) Erfinder: Pihale, Sven, 38440 Wolfsburg (DE); Wilke, Robert, 38440 Wolfsburg (DE); Otto, Alexander, 38440 Wolfsburg (DE); Dedeleit, Lukas, 38440 Wolfsburg (DE); Hiller, Sebastian, 38440 Wolfsburg (DE); Kraft, Silke, 38440 Wolfsburg (DE)

(57) **Zusammenfassung**

Die Erfindung betrifft eine Leistungselektronik (20) mit einem Kühlkörper (30, 30', 30", 30"'), insbesondere für einen Elektroantrieb eines Fahrzeugs.

Der Erfindung liegt die Aufgabe zugrunde, auf einfache Weise einen Kühlkörper (30, 30', 30", 30‴) für eine Leistungselektronik (20) zu schaffen, der einen guten Schutz vor Kondensatbildung bietet.

Es wird vorgeschlagen, dass mindestens eine Oberfläche des Kühlkörpers (30, 30', 30", 30"') zumindest teilweise mit einer flüssigkeitsaufnehmenden Schicht (38, 38', 38", 38‴) versehen ist.

## Beschreibung

Die Erfindung betrifft eine Leistungselektronik mit einem Kühlkörper, insbesondere für einen Elektroantrieb eines Fahrzeugs.

Die Leistungselektronik für Hybridfahrzeuge oder Elektrofahrzeuge besteht in der Regel aus mindestens einem Inverter (auch als Pulswechselrichter bezeichnet), welche von der Batterie gespeist werden und den Elektromotor mit den anforderungsgerechten Wechselströmen versorgen. Die Bauelemente der Leistungselektronik sind in der Regel auf einem Kühlkörper montiert, der von Wasser durchströmt sein kann. Der Kühlkörper besteht im Allgemeinen aus einem metallischen Werkstoff und führt die in den Bauelementen der Leistungselektronik entstehende Wärme ab. Auf dem Kühlkörper können weitere elektronische Komponenten, wie mindestens eine Steuerplatine oder ein Kondensator, angeordnet sein.

Im Ruhezustand des Fahrzeugs entsteht in den Bauelementen der Leistungselektronik keine Wärme und der Kühlkörper kühlt sich auf Umgebungstemperatur ab. Insbesondere bei Umgebungstemperaturen nahe dem Gefrierpunkt besteht die Gefahr, dass an dem Kühlkörper Luftfeuchtigkeit kondensiert. Das Kondensat kann Tropfen bilden und elektronische Bauelemente, die an oder nahe dem Kühlkörper montiert sind, befeuchten. Hierdurch kann es zu Kriechströmen und insbesondere zu Fehlfunktionen der Elektronik im PWR kommen.

Es sei darauf hingewiesen, dass auch bei stationären Anwendungen Kühlkörper für elektronische Bauelemente einer Leistungselektronik verwendet werden. Auch hier besteht die Gefahr der Kondensatbildung, insbesondere bei Umgebungstemperaturen nahe dem Gefrierpunkt.

Aus DE 10 2020 119 727 A1 ist die Verwendung eines Absorbermaterials bekannt, das eine Hülle und in dieser angeordnete superabsorbierende Partikel zur Aufnahme und/oder Verteilung von Flüssigkeiten in einem aktiv und/oder passiv gekühlten Stromspeichersystem aufweist. Dabei ist die Hülle aus mindestens zwei flächig aufeinander angeordneten Lagen gebildet, wobei die Lagen bereichsweise derart durch mindestens eine Naht miteinander verbunden sind, dass sich eine Segmentierung der Hülle in Form von voneinander abgegrenzten Taschen ergibt und wobei zumindest ein Teil der Taschen die superabsorbierenden Partikel aufweist. Die Verwendung des Absorbermaterials ist ausschließlich derart beschrieben, dass dieses unterhalb eines Kühlsystems angeordnet ist, so dass austretende Kühlflüssigkeit aus dem Kühlsystem oder sich ausscheidendes Kondensat schwerkraftbedingt zu dem Absorbermaterial gelangt und in dieses eindringt. Mit den Taschen soll verhindert werden, dass sich das Absorbermaterial partiell so weit ausdehnt, dass nach einem partiellen Aufquellen des Absorbermaterials ein weiteres Eindringen von Flüssigkeit in das Absorbermaterial verhindert wird (Blocking Effekt).

Der Erfindung liegt die Aufgabe zugrunde, auf einfache Weise einen Kühlkörper für eine Leistungselektronik zu schaffen, der einen guten Schutz vor Kondensatbildung bietet.

Die Lösung der Aufgabe erfolgt erfindungsgemäß mit den Merkmalen der unabhängigen Ansprüche. Weitere praktische Ausführungsformen und Vorteile der Erfindung sind in Verbindung mit den abhängigen Ansprüchen beschrieben.

Bei einer Leistungselektronik mit einem Kühlkörper ist gemäß dem hier beschriebenen Vorschlag mindestens eine Oberfläche des Kühlkörpers zumindest teilweise mit einer flüssigkeitsaufnehmenden Schicht versehen.

Mit anderen Worten, wird beispielsweise die Oberseite oder die Unterseite des Kühlkörpers mit einer Absorberschicht ausgestattet, die die Bildung von Kondensat behindert oder zumindest dafür sorgt, dass das gebildete Kondensat in der Schicht aufgenommen wird und nicht zu größeren Tropfen zusammenfließt, die in die Nähe der elektronischen Bauteile gelangen können.

Das Aufbringen einer flüssigkeitsaufnehmenden Absorberschicht ist insbesondere an den zur Kondensation neigenden Teilflächen, beispielsweise im Bereich der Kühlwasserzufuhr, hilfreich. Ein sehr effektiver Schutz gegen Kondensatbildung kann dadurch erzielt werden, dass alle freiliegenden Oberflächen des Kühlkörpers mit einer feuchtigkeitsaufnehmenden Schicht versehen sind. In den Kontaktbereichen des Kühlkörpers, welche in physischem Kontakt mit den elektronischen Komponenten der Leistungselektronik stehen, sollte die flüssigkeitsaufnehmende Schicht allerdings unterbrochen sein, um die Wärmeübertragung zwischen den elektronischen Komponenten und dem Kühlkörper nicht zu behindern.

In der Praxis kann die flüssigkeitsaufnehmende Schicht porös sein. Eine Schicht wird als porös definiert, wenn sie eine Struktur aufweist, die viele kleine, miteinander verbundene Hohlräume oder Poren aufweist, welche die Bildung von Wassertropfen vermeiden, aber auch Wasser aufnehmen und binden können. Diese Poren können die physikalischen Eigenschaften der Schicht beeinflussen, wie z.B. ihre Durchlässigkeit für Flüssigkeiten oder Gase, ihre Festigkeit und ihre thermischen Eigenschaften. Die Porosität ist eine dimensionslose Messgröße, die das Verhältnis von Hohlraumvolumen zu Gesamtvolumen beschreibt. Die Porosität einer Oberflächenschicht wird dadurch erreicht, dass die Oberfläche eine Vielzahl kleiner Poren, in der Regel mit einer Porengröße von wenigen Nanometern (nm) bis zu mehreren Mikrometern (µm), in hoher Dichte aufweist.

Beispielsweise werden Schutzanstriche mit porösen Schichteigenschaften verwendet, um in der Bautechnik Oberflächen derart zu beschichten, dass Kondenswasser sich darin ansammelt und nicht abfließt. Im Betrieb der Leistungselektronik erwärmt sich der Kühlkörper in aller Regel auf Temperaturen oberhalb von 50 °C, je nach Betriebszustand auch oberhalb von 80 °C. So ist gewährleistet, dass beim normalen Betrieb der Leistungselektronik die in der wasseraufnehmenden Schicht angesammelte Feuchtigkeit in die Umgebung verdampft. Nach dem Verdampfen der aufgenommenen Flüssigkeiten ist die flüssigkeitsaufnehmende Schicht wieder für die Absorption neuen Kondenswassers bereit.

Die flüssigkeitsaufnehmende Schicht kann in einer Ausführungsform als Anstrich auf die Oberfläche des Kühlkörpers aufgetragen werden. Beispielsweise bietet die Firma M2 Entwicklungs-, Produktions- & Vertriebs-GmbH unter der Markenbezeichnung ISO*-Therm Antikondensbeschichtungen an, die hygroskopische Eigenschaften aufweisen. Die Beschichtungen können aufgestrichen oder aufgesprüht werden.

Alternativ zu porösen Schutzlacken können auch microskalige Schaumstrukturen auf die Oberfläche des Kühlkörpers aufgetragen werden. Solche schaumartigen Schichten können beispielsweise im Auftragsverfahren des Kaltgasspritzens oder durch additive Fertigungsverfahren auf die Oberfläche des Kühlkörpers aufgetragen werden. In einer Ausführungsform kann eine Zeolith-Schicht auf der Oberfläche des Kühlkörpers ausgebildet werden. Zeolithische Strukturen bestehen aus hydratisierten Aluminosilikaten, welche verbundenes Aluminiumoxid (AlO₄) und Siliziumdioxid (SiO₄) mit einer dreidimensionalen Kristallstruktur aufweisen. Zeolithische Strukturen können z.B. über den chemischen Sol-Gel-Prozess gebildet werden und unmittelbar auf der Oberfläche des Kühlkörpers, bevorzugt als Schicht, appliziert werden. Die Bestandteile solcher Nanocomposite besitzen oft eine definierte Größe von 1 - 100 nm und bilden durch Vernetzung der einzelnen Bestandteile eine Schicht aus. Eine daraus resultierende Schicht kann somit eine Schichtdicke im Bereich von wenigen hundert Nanometern bis hin zu mehreren Micrometern je nach Ausführungs- und Gestaltungsform haben. Die Porosität von Zeolithen ist bemerkenswert hoch und variiert je nach Typ und Struktur des Zeoliths. Im Allgemeinen besitzen Zeolithe eine innere Oberfläche von weit über 1.000 Quadratmetern pro Gramm. Diese hohe Porosität ist auf das Netzwerk von gleichförmigen Poren und Kanälen zurückzuführen, die durch die kristalline Gerüststruktur der Zeolithe gebildet werden. Die Porengröße kann zwischen Mikro- und Mesoporen variieren, was die Fähigkeit der Zeolithe zur Adsorption und zum Ionenaustausch beeinflusst. Im Allgemeinen haben Zeolithe Mikroporen von 0,3 - 1 Nanometer und Mesoporen mit einer Porengröße von 2 - 50 Nanometer. Das typische Eigengewicht von Zeolithen variiert je nach Typ und Struktur, liegt aber im Allgemeinen zwischen 2,0 und 2,2 Gramm pro Kubikzentimeter (g/cm³). Diese Dichte ist auf die komplexe Kristallstruktur und die hohe Porosität der Zeolithe zurückzuführen, z. B. Zeolith A Struktur: Dieser Typ wird häufig in Waschmitteln und als Trockenmittel verwendet. Zeolith A kann bis zu 30 % seines Eigengewichts an Wasser aufnehmen.

Schließlich können auch textile Faserstrukturen wie Faserflocken oder Faservliese beispielsweise durch Verkleben auf die Oberfläche des Kühlkörpers aufgebracht werden und dort eine poröse, feuchtigkeitsaufnehmende Struktur bilden.

Alternativ zum Auftragen der flüssigkeitsaufnehmenden Schicht auf die Oberfläche des Kühlkörpers ist es auch möglich, die flüssigkeitsaufnehmende Schicht durch eine Reaktion auf der Oberfläche des Kühlkörpers auszubilden. Wie eingangs erwähnt, besteht der Kühlkörper, vorzugsweise aus Metall, beispielsweise aus Aluminium oder Kupfer. Insbesondere auf Aluminium kann durch eine geeignete Reaktionsdispersion eine Alumosilikat-Zeolith-Schicht ausgebildet werden, die eine hohe Wassersorptionskapazität aufweist. Ein Verfahren zu einer derartigen Ausbildung einer Alumosilikat-Zeolith-Schicht ist in der Druckschrift DE 10 2015 122 301 B4 offenbart.

Es ist auch möglich, auf Kühlkörpern aus Aluminium eine anodisierte Aluminiumoxidschicht (AAO-Schicht) auszubilden. Die Herstellung von flexiblen und mechanisch stabilen porösen Aluminiumoxidschichten mittels anodischer Oxidation wird beispielsweise von Komorowska et al. in einer Publikation auf der Webseite www.wotech-technical-media.de beschrieben. Grundsätzlich ist jegliche poröse Festkörperschicht dazu geeignet, der Kondensatbildung auf der Oberfläche eines Kühlkörpers entgegenzuwirken. Neben den bereits erwähnten porösen Lacken, Schäumen, insbesondere Metallschäumen, Zeolithen und Oxidschichten, sind auch Faserschichten geeignet, eine feuchtigkeitsaufnehmende Schicht auf der Oberfläche des Kühlkörpers zu bilden. Um eine faserige Schicht auf der Oberfläche des Kühlkörpers zu bilden, kann beispielsweise ein abbindender Klebstoff aufgetragen werden, der mit Fasern oder Faserflocken bestreut wird. Alternativ kann ein textiles Flächengebilde auf einer Seite mit einem Klebstoff versehen und auf die Oberfläche des Kühlkörpers aufgeklebt werden. An den Fasern des textilen Flächengebildes haftet Feuchtigkeit. Insbesondere ein Faservlies hat eine hohe Porosität und kann viel Flüssigkeit aufnehmen.

Die flüssigkeitsaufnehmende Schicht, insbesondere mit poröser Oberflächenstruktur, kann auch durch ein Ätzverfahren auf der metallischen Oberfläche des Kühlkörpers ausgebildet werden. Es können auch Materialkombinationen auf der Oberfläche des Kühlkörpers vorgesehen werden, wie z.B. Oberflächen aus Ätzverfahren oder aus additiven Verfahren und zusätzlicher nasschemisch erzeugter zeolithischer Strukturen. Kombinationen können eine weitere Verbesserung der Wasseraufnahme begünstigen.

Es ist darauf zu achten, das Textilfasern verwendet werden, die bei den Betriebstemperaturen des Kühlkörpers (bis zu 90 °C) beständig sind. Die elektronischen Bauelemente, die mit dem Kühlkörper verbunden sind, können insbesondere im Falle einer Leistungselektronik für ein Fahrzeug folgendes umfassen:
- Halbbrücken-Leistungsmodul;
- FSM-Erregermodul.

Da Elektroantriebe für Fahrzeuge häufig mit Dreiphasendrehstrom betrieben werden, kann die Leistungselektronik in der Praxis drei Halbbrücken-Leistungsmodule umfassen. Fremderregte Synchronmaschinen (FSM) benötigen Erregermodule für den Betrieb.

Ein Verfahren zur Herstellung einer Leistungselektronik, die einen Kühlkörper aufweist, umfasst den Schritt, dass mindestens eine Oberfläche des Kühlkörpers zumindest teilweise mit einer flüssigkeitsaufnehmenden Schicht versehen wird.

Die flüssigkeitsaufnehmende Schicht kann auf die Oberfläche des Kühlkörpers aufgetragen werden, wie oben erwähnt, beispielsweise durch Aufsprühen, Kaltgasspritzen, im additiven Fertigungsverfahren z.B. durch Aufschmelzen mittels Laser (selektives Laserschmelzen - SLM oder selektives Lasersintern - SLS) oder durch chemische Beschichtung. Beim additiven Auftrag der Schicht können die Poren der Schicht ausgebildet werden. Alternativ kann eine poröse Schicht unmittelbar auf der Oberfläche des Kühlkörpers ausgebildet werden, beispielsweise durch Bildung einer Aluminiumoxidschicht auf einem Kühlkörper aus Aluminium mittels anodischer Oxidation oder durch Bildung einer Alumosilikat-Zeolith-Schicht mittels einer wässrigen Reaktionsdispersion.

Wie ebenfalls oben angesprochen, ist es vorteilhaft, dass der Kontakt zwischen den elektronischen Bauelementen und dem Kühlkörper frei von einer flüssigkeitsaufnehmenden Schicht ist, um einen möglichst guten Wärmeübergang zu gewährleisten. Um dies zu erreichen, können zunächst elektronische Bauelemente an dem Kühlkörper befestigt werden und anschließend die flüssigkeitsaufnehmende Schicht auf die Oberfläche des Kühlkörpers aufgebracht werden.

Alternativ kann zunächst die flüssigkeitsaufnehmende Schicht auf die Oberfläche des Kühlkörpers aufgebracht werden, wobei Flächenabschnitte erzeugt werden, die von der flüssigkeitsaufnehmenden Schicht frei sind. Anschließend können elektronische Bauelemente an den von der flüssigkeitsaufnehmenden Schicht freien Flächenabschnitten des Kühlkörpers befestigt werden. Beispielsweise kann die Oberfläche des Kühlkörpers vor dem Auftragen oder Erzeugen der flüssigkeitsaufnehmenden Schicht in bestimmten Flächenabschnitten durch Masken abgedeckt oder abgeklebt werden. Dies können entweder folienartige Masken sein oder aufgetragene Maskierungslacke. Nach dem Auftragen oder Aufbringen der flüssigkeitsaufnehmenden Schicht werden die Masken entfernt und die elektronischen Bauelemente auf die von der flüssigkeitsaufnehmenden Schicht freien Flächenabschnitte des Kühlkörpers aufgetragen. Schließlich kann alternativ eine vollflächige flüssigkeitsaufnehmende Schicht vorgesehen werden und die freien Flächenabschnitte durch mechanische Bearbeitung, z.B. Fräsen oder Schleifen, erzeugt werden, bevor darauf die elektronischen Bauelemente angebracht werden.

Weitere praktische Ausführungsformen der Erfindung sind nachfolgend im Zusammenhang mit den Zeichnungen beschrieben. Es zeigen:
- Fig. 1: eine schematische Darstellung eines Gehäuses eines Pulswechselrichters mit den darin befindlichen Komponenten,
- Fig. 2: eine dreidimensionale Ansicht der elektronischen Bauteile einer Leistungselektronik auf einem Kühlkörper,
- Fig. 3: eine schematische Schnittdarstellung eines Abschnitts der Oberfläche des Kühlkörpers aus Figur 2,
- Fig. 4: eine alternative Ausführungsform eines Abschnitts der Oberfläche des Kühlkörpers aus Figur 2,
- Fig. 5: eine weitere alternative Ausführungsform eines Abschnitts der Oberfläche des Kühlkörpers aus Figur 2.

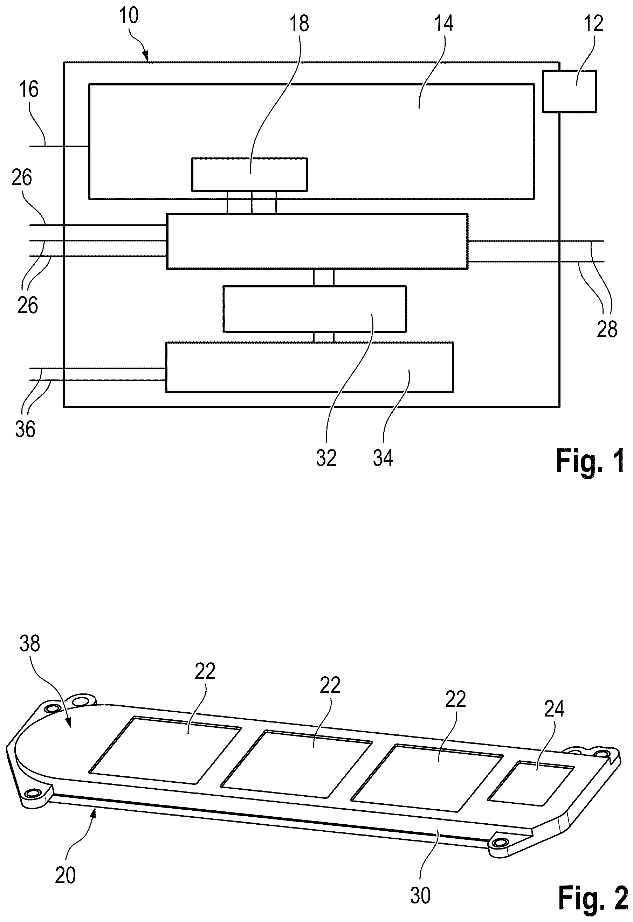

In Figur 1 ist schematisch ein Gehäuse 10 eines Pulswechselrichters zu erkennen. In der oberen rechten Ecke ist ein Luftaustauschelement 12 dargestellt, welches von einem Druckausgleichsventil gebildet wird, das für den Luftausgleich in dem Gehäuse 10 sorgt. Das Luftaustauschelement 12 verhindert schon weitgehend das Eintreten von Feuchtigkeit in das Innere des Gehäuses 10 des Pulswechselrichters. Allerdings wird der Eintritt von Umgebungsluft mit der Umgebungstemperatur im Bereich des Pulswechselrichters und der dort herrschenden Luftfeuchtigkeit zugelassen. Insbesondere bei hoher Betriebstemperatur nahe 100 °C ist die zulässige Luftfeuchtigkeit hoch. Im Gehäuses 10 des Pulswechselrichters, das zum Beispiel ein Volumen von 2 - 3 Liter aufweisen kann, kann die Luft bei Betriebstemperatur über 100 mg Wasser enthalten, welches beim Abkühlen auskondensieren kann.

Innerhalb des Gehäuses 10 ist eine Steuerplatine 14 angeordnet, die über ein Kommunikationsinterface 16 mit der Fahrzeugelektronik verbunden ist. Ein Gatetreiber 18, der auf der Steuerplatine 14 angebracht ist, dient der Ansteuerung der Leistungselektronik 20. Die Leistungselektronik 20 ist in Figur 2 detailliert dargestellt. Sie umfasst drei Halbbrücken-Leistungsmodule 22 und ein Erregermodul 24 für eine fremderregte Synchronmaschine. In der Figur 1 sind schematisch die drei elektrischen Leiter 26 dargestellt, welche den Strom von den Halbbrücken-Leistungsmodulen 22 zum Motor leiten. Ferner sind in Figur 1 schematisch die zwei Fluidleitungen 28 zu erkennen, über die Kühlflüssigkeit zur Leistungselektronik 20 hin- und von ihr weggeleitet wird. In Figur 2 ist zu erkennen, dass die Halbbrücken-Leistungsmodule 22 sowie das Erregermodul 24 auf einem Kühlkörper 30 montiert sind. Dieser Kühlkörper 30 wird von der Kühlflüssigkeit durchströmt, welche über die Fluidleitungen 28 zugeleitet wird und wieder abtransportiert wird.

In Figur 1 ist schließlich ein Zwischenkreiskondensator 32 sowie ein EMV-Filter 34 dargestellt, welche jeweils über ein Paar elektrischer Leiter miteinander verbunden sind. Ferner sind die zwei elektrischen Leiter 36 zu erkennen, über die der Gleichstrom von der Batterie dem EMV-Filter 34 zugeführt wird. In Figur 2 ist schematisch dargestellt, dass die gesamte zwischen den elektronischen Bauelementen 22, 24 der Leistungselektronik 20 angeordnete Oberfläche mit einer flüssigkeitsaufnehmenden Schicht 38 versehen ist. Die flüssigkeitsaufnehmende Schicht 38 bindet Kondenswasser, das sich vorzugsweise an dem Kühlkörper 30 der Leistungselektronik 20 ablagert. In Figur 2 ist die flüssigkeitsaufnehmende Schicht 38 nur auf der Oberseite zwischen den elektronischen Bauelementen 22, 24 der Leistungselektronik 20 dargestellt. Der Kühlkörper 30 kann aber auch auf der gegenüberliegenden Seite sowie auf den Randflächen mit einer flüssigkeitsaufnehmenden Schicht 38 versehen sein.

Bereits durch das Luftaustauschelement 12 ist sichergestellt, dass ein Flüssigkeitseintritt in das Gehäuse 10 des Pulswechselrichters weitgehend vermieden wird. Allerdings tritt insbesondere bei der Leistungselektronik von Fahrzeugen bei längerem Stillstand des Fahrzeuges eine gewisse Menge an Luftfeuchtigkeit durch das Luftaustauschelement 12 in das Gehäuse 10 ein. Um insbesondere zu verhindern, dass die Leistungselektronik 20 durch einen Flüssigkeitsfilm auf der Oberfläche des Kühlkörpers 30 in irgendeiner Weise gestört wird, ist die Oberfläche des Kühlkörpers 30 mit der flüssigkeitsaufnehmenden Schicht 38 versehen.

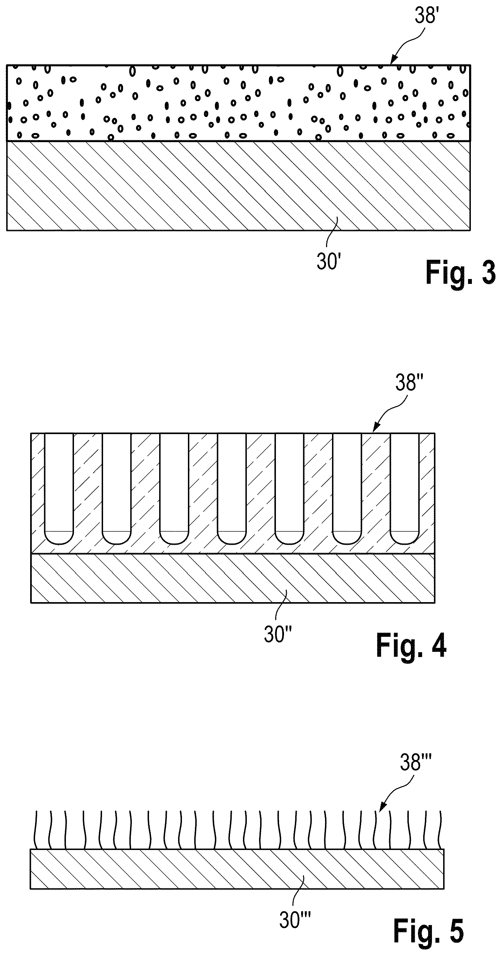

Figur 3 zeigt eine vergrößerte geschnittene Darstellung einer ersten Ausführungsform der Oberfläche des Kühlkörpers 30'. Der Kühlkörper 30' besteht aus Aluminium. Auf seiner Oberfläche ist als flüssigkeitsaufnehmende Schicht 38' eine schaumartige poröse Schicht aufgebracht, die beispielsweise in einem additiven Fertigungsverfahren durch selektives Laserschmelzen oder selektives Lasersintern aufgebracht sein kann.

Die Figur 4 zeigt eine alternative Ausführungsform der flüssigkeitsaufnehmenden Schicht 38". Diese ist als poröse Aluminiumoxidschicht auf den Kühlkörper 30" aufgebracht, welche durch Anodisieren auf der Oberfläche des Kühlkörpers 30" aus Aluminium erzeugt wird. Ein mögliches Verfahren zur Erzeugung einer derartigen Schicht ist in der oben genannten Publikation auf www.wotech-technical-media.de von Komorowska et al. offenbart.

Figur 5 zeigt schließlich eine Variante einer flüssigkeitsaufnehmenden Schicht 38"', bei der auf den metallischen Kühlkörper 30"' textile Fasern aufgeflockt sind. Die textilen Fasern der flüssigkeitsaufnehmenden Schicht 38"' können mit einem geeigneten Klebstoff an dem Kühlkörper 30"' aus Aluminium oder einem anderen geeigneten Material befestigt sein. Alternativ zur Beflockung mit textilen Fasern kann auch ein Faservlies auf die Oberfläche des Kühlkörpers 30"' aufgeklebt werden. Bei einem Faservlies sind die Fasern miteinander verfilzt und weisen eine hohe Porosität auf.

Die in der vorliegenden Beschreibung, in den Zeichnungen sowie in den Ansprüchen offenbarten Merkmale der Erfindung können sowohl einzeln als auch in beliebigen Kombinationen für die Verwirklichung der Erfindung in ihren verschiedenen Ausführungsformen wesentlich sein. Die Erfindung kann im Rahmen der Ansprüche und unter Berücksichtigung der Kenntnisse des zuständigen Fachmanns variiert werden.

### Bezugszeichenliste

- 10: Gehäuse
- 12: Luftaustauschelement
- 14: Steuerplatine
- 16: Kommunikationsinterface
- 18: Gatetreiber
- 20: Leistungselektronik
- 22: Halbbrücken-Leistungsmodul
- 24: Erregermodul
- 26: elektrische Leiter
- 28: Fluidleitung
- 30, 30', 30", 30"': Kühlkörper
- 32: Zwischenkreiskondensator
- 34: EMV-Filter
- 36: elektrische Leiter
- 38, 38', 38", 38"': flüssigkeitsaufnehmende Schicht

## Patentansprüche

1. Leistungselektronik (20) mit einem Kühlkörper (30, 30', 30", 30"'),
**dadurch gekennzeichnet,**
**dass** mindestens eine Oberfläche des Kühlkörpers (30, 30', 30", 30"') zumindest teilweise mit einer flüssigkeitsaufnehmenden Schicht (38, 38', 38", 38"') versehen ist.

2. Leistungselektronik (20) nach dem vorangehenden Anspruch, **dadurch gekennzeichnet, dass** die flüssigkeitsaufnehmende Schicht (38, 38', 38", 38"') porös ist.

3. Leistungselektronik (20) nach einem der vorangehenden Ansprüche, **dadurch gekennzeichnet, dass** der Kühlkörper (30, 30', 30", 30"') aus Metall, insbesondere aus Aluminium oder Kupfer besteht.

4. Leistungselektronik (20) nach einem der vorangehenden Ansprüche, **dadurch gekennzeichnet, dass** die flüssigkeitsaufnehmende Schicht (38, 38', 38", 38"') gemäß mindestens einem der folgenden Merkmale ausgebildet ist:
• sie ist auf die Oberfläche des Kühlkörpers (30, 30', 30"') aufgetragen;
• sie ist durch eine Reaktion auf der Oberfläche des Kühlkörpers (30") ausgebildet.

5. Leistungselektronik (20) nach einem der vorangehenden Ansprüche, **dadurch gekennzeichnet, dass** die flüssigkeitsaufnehmende Schicht (38, 38', 38", 38"') mindestens eine der folgenden Materialien aufweist:
• porösen Lack;
• porösen Metallschaum;
• Zeolithe;
• Aluminiumoxid;
• Faserstrukturen.

6. Leistungselektronik (20) nach einem der vorangehenden Ansprüche, **dadurch gekennzeichnet, dass** mit dem Kühlkörper (30, 30', 30", 30"') mindestens eins der folgenden elektronischen Bauelemente verbunden ist:
• Halbbrücken-Leistungsmodul (22);
• FSM-Erregermodul (24).

7. Verfahren zur Herstellung einer Leistungselektronik (20), die einen Kühlkörper (30, 30', 30", 30"') aufweist,
**dadurch gekennzeichnet,**
**dass** mindestens eine Oberfläche des Kühlkörpers (30, 30', 30", 30"') zumindest teilweise mit einer flüssigkeitsaufnehmenden Schicht (38, 38', 38", 38"') versehen wird.

8. Verfahren nach dem vorangehenden Anspruch, **dadurch gekennzeichnet, dass** die flüssigkeitsaufnehmende Schicht (38, 38', 38", 38"') gemäß zumindest einem der folgenden Verfahren auf die Oberfläche des Kühlkörpers (30, 30', 30", 30"') aufgebracht wird:
• sie wird auf die Oberfläche des Kühlkörpers (30, 30', 30", 30"') aufgetragen;
• sie wird durch eine Reaktion auf der Oberfläche des Kühlkörpers (30, 30', 30", 30"') ausgebildet.

9. Verfahren nach einem der Ansprüche 7 und 8, **dadurch gekennzeichnet, dass** zunächst elektronische Bauelemente (22, 24) an dem Kühlkörper (30, 30', 30", 30"') befestigt werden und anschließend die flüssigkeitsaufnehmende Schicht (38, 38', 38", 38‴) auf die Oberfläche des Kühlkörpers (30, 30', 30", 30"') aufgebracht wird.

10. Verfahren nach einem der Ansprüche 7 und 8, **dadurch gekennzeichnet, dass** zunächst die flüssigkeitsaufnehmende Schicht (38, 38', 38", 38"') auf die Oberfläche des Kühlkörpers (30, 30', 30", 30"') aufgebracht wird, dass von der flüssigkeitsaufnehmenden Schicht (38, 38', 38", 38"') freie Flächenabschnitte erzeugt werden, und dass elektronische Bauelemente (22, 24) an den von der flüssigkeitsaufnehmenden Schicht (38, 38', 38", 38"') freien Flächenabschnitten des Kühlkörpers (30, 30', 30", 30"') befestigt werden.
